# EUROPÄISCHE PATENTSCHRIFT

(11) **EP 2 526 217 B1**
(45) Veröffentlichungstag und Bekanntmachung des Hinweises auf die Patenterteilung: **15.02.2017**
(21) Anmeldenummer: 10795619.5
(22) Anmeldetag: 16.12.2010
(51) Int. Cl.: C23C 14/00, C23C 14/08, H01L 31/0224

(54) **VERFAHREN ZUM VAKUUMBESCHICHTEN EINES SUBSTRATES MIT EINEM TRANSPARENTEN LEITFÄHIGEN METALLEGIERUNGSOXID SOWIE EINE TRANSPARENTE LEITFÄHIGE SCHICHT AUS EINEM METALLEGIERUNGSOXID**
METHOD FOR VACUUM-COATING A SUBSTRATE WITH A TRANSPARENT, CONDUCTIVE METAL ALLOY OXIDE AND A TRANSPARENT, CONDUCTIVE LAYER MADE OF A METAL ALLOY OXIDE
PROCÉDÉ DE REVÊTEMENT SOUS VIDE D'UN SUBSTRAT PAR UN OXYDE D'ALLIAGE MÉTALLIQUE CONDUCTEUR TRANSPARENT ET COUCHE CONDUCTRICE TRANSPARENTE FAITE D'UN OXYDE D'ALLIAGE MÉTALLIQUE

(30) Priorität: 19.01.2010 DE 102010004991
(43) Veröffentlichungstag der Anmeldung: 28.11.2012
(73) Patentinhaber: Fraunhofer-Gesellschaft zur Förderung der angewandten Forschung, 80686 München (DE)
(72) Erfinder: FAHLAND, Matthias, 01257 Dresden (DE); SCHÖNBERGER, Alexander, 01169 Dresden (DE); SCHÖNBERGER, Waldemar, 01109 Dresden (DE); STRAACH, Steffen, 01187 Dresden (DE); SCHILLER, Nicolas, 01833 Stolpen OT Helmsdorf (DE)
(86) Internationale Anmeldenummer: PCT/EP2010/007673
(87) Internationale Veröffentlichungsnummer: WO 2011/088875

(56) Entgegenhaltungen:
- JP-A- 2006 147 325
- US-A1- 2003 035 906
- US-A1- 2008 261 070
- SZYSZKA B ET AL: "Transparent and conductive ZnO:Al films deposited by large area reactive magnetron sputtering", THIN SOLID FILMS, ELSEVIER-SEQUOIA S.A. LAUSANNE, CH, Bd. 442, Nr. 1-2, 1. Oktober 2003 (2003-10-01), Seiten 179-183, XP004458319, ISSN: 0040-6090, DOI: DOI:10.1016/S0040-6090(03)00968-4

## Beschreibung

Die Erfindung betrifft ein Vakuumverfahren zum Abscheiden einer Schicht aus einem transparenten leitfähigen Metalllegierungsoxid. Dabei umfasst das Metalllegierungsoxid ein Wirtsmaterial, in welches ein Dotiermaterial eingelagert wird, wobei die Konzentration des Dotiermaterials innerhalb des Wirtsmaterials im Schichtdickenverlauf mit einem Gradienten ausgebildet wird. Als Wirtsmaterial im erfindungsgemäßen Sinne sind solche Schichtbestandteile anzusehen, die einen molaren Anteil am Metalllegierungsoxid von mindestens 90 % aufweisen.

### Stand der Technik

Transparente leitfähige Schichten werden in zahlreichen technischen Geräten verwendet. Typische Anwendungen sind zum Beispiel Flachbildschirme, Dünnschicht-Solarzellen, elektronisches Papier und mobile Geräte mit Bildschirm-Eingabefunktionen. Als leitfähig im Sinne der hier dargestellten Erfindung sind solche Materialien zu verstehen, deren spezifischer Widerstand niedriger als 0,1 Ωcm ist. Als transparent im Sinne der hier dargestellten Erfindung sind solche Materialien anzusehen, die bei einer Schichtdicke von 1 µm einen einfallenden Lichtstrahl (Wellenlänge 550 nm) um nicht mehr als 60 % abschwächen.

Weit verbreitet ist das Herstellen von transparenten Schichten aus leitfähigen Metalllegierungsoxiden (transparent conducting oxide, TCO). Derartige Schichten bestehen aus einem Wirtsmaterial und einem Dotiermaterial. TCO, die kein Dotiermaterial enthalten, sondern bei denen die Leitfähigkeit nur über ein Defizit an Sauerstoff eingestellt wird, sind nicht Gegenstand dieser Erfindung und werden im Folgenden auch nicht diskutiert.

Das TCO mit der wichtigsten praktischen Bedeutung ist Indium-Zinn-Oxid (ITO, das Verhältnis von Indium zu Zinn beträgt dabei in etwa 90:10 Gewichts-%). Es hat einen spezifischen Widerstand im Bereich von 1x10⁻⁴ Ωcm bis 6x10⁻⁴ Ωcm. Die höheren elektrischen Widerstände beim ITO werden dann erzielt, wenn ein zu beschichtendes Substrat während der Beschichtung nicht wesentlich über Raumtemperatur erwärmt wird (Temperatur <100°C).

Aus US 2003/0035906 A1 ist ein Schichtsystem bestehend aus drei übereinander abgeschiedenen transparenten ITO-Schichten bekannt, bei welchem aneinandergrenzende ITO-Schichten einen unterschiedlichen Anteil an Indium- und Zinnoxid aufweisen. Auf diese Weise ist es möglich einen Gradienten bezügliche der Schichtzusammensetzung auszubilden. Nachteilig wirkt sich dabei aus, dass hierfür drei separate Beschichtungsvorgänge erforderlich sind.

Eine Alternative zum ITO stellt das Indium-Zink-Oxid (IZO) dar, mit dem sich auf nicht beheizten Substraten Widerstandswerte einstellen lassen, die kleiner sind als 5x10⁻⁴ Ωcm (WO 03/024712 A1).

Beiden Materialien ist eigen, dass sie einen sehr hohen Gehalt des Metalls Indium aufweisen. Für dieses Material gibt es nur begrenzte Ressourcen, die schon in der Vergangenheit zu starken Preisanstiegen geführt haben. Das ist speziell dann nachteilig, wenn die transparente Elektrode preiswert sein soll oder wenn ein sehr niedriger Flächenwiderstand gefordert ist, was bei diesen beiden TCO eine große Schichtdicke erfordert. Ferner haben die Materialien ITO und IZO nur eine beschränkte Transparenz im Spektralbereich der elektromagnetischen Strahlung zwischen 1000 nm und 2000 nm, was sich negativ beim Einsatz in Solarzellen auswirkt.

Aus den genannten Gründen wurde alternativ Zinkoxid als Ausgangsmaterial für transparente leitfähige Schichten verwendet. Zinkoxid muss jedoch ein Dotiermaterial hinzugefügt werden, um einen elektrischen Widerstand im Bereich 2x10⁻⁴ Ωcm bis 2x10⁻³ Ωcm zu erreichen. Als zusätzliches Element wird meist ein Element der 3 Hauptgruppe verwendet. Vorzugsweise wird Aluminium als Dotiermaterial verwendet. Das typische Verhältnis zwischen dem Mengenanteil von Aluminium und dem Mengenanteil von Zink (jeweils in Atom-%) liegt dabei zwischen 0.5 und 5. Alternativ zu Aluminium wird auch Gallium als Dotiermaterial eingesetzt (JP 2006147325 A). Ferner wurden auch Verbindungen mit mehreren Elementen als Dotierungen vorgeschlagen (JP 6293956 A).

Gegenwärtig werden sowohl TCO-Schichten mit allen oben genannten Wirtsgittern hauptsächlich durch Festkörperzerstäubung (Sputtern) hergestellt. Dazu wird ein Block des gewünschten Schichtmaterials (Target) mit Edelgasionen beschossen. Diese lösen aus dem Verbund des Blocks einzelne Atome heraus, die sich anschließend als Schicht auf dem Substrat niederschlagen.

Eine weit verbreitete Einrichtung für das Sputtern ist das Magnetron, bei dem durch eine entsprechende elektrische Beschaltung und die Überlagerung eines magnetischen Feldes ein hoher Abtrag des schichtbildenden Targetmaterials erreicht wird. Dabei kommen sowohl planare Magnetrons als auch Rohrmagnetrons zum Einsatz (DE 10 2008 009 339 A1). Bei diesen Verfahren stammt das abgeschiedene Schichtmaterial ausschließlich aus dem Material des Targets. Da derartige TCO-Schichten keramische Schichten sind, werden derartige Targets auch keramische Targets genannt.

Ein alternatives Beschichtungsverfahren für TCO ist das reaktive Sputtern, bei dem ein rein metallisches Target verwendet wird. Entsprechend muss bei solch einem Prozess zusätzlich Sauerstoff über die Gasphase zugeführt werden. Darüber hinaus ist eine sehr präzise Prozesskontrolle erforderlich, um die gewünschten Eigenschaften zu erreichen [B. Szyszka et al. SVC 48rd Annual Technical Conference Proceedings (2005) 691].

Weitere Verfahren zum Abscheiden von TCO bedienen sich der chemischen Dampfabscheidung, bei der ein Gemisch aus verschiedenen gasförmigen Ausgangsmaterialien auf dem Substrat zur Reaktion gebracht wird [S. Fay et al. Thin Solid Films 515 (2007) 8558]. Dabei werden sowohl die Ausgangsmaterialien für das Wirtsmaterial (in diesem Fall Diethylzink und Wasser) als auch für das Dotiermaterial (B₂H₆) als Gase eingelassen.

Ferner werden TCO-Schichten durch Laserablation hergestellt [Naghavi et al. Thin Solid Films 360 (2000) 233].

Alle genannten Verfahren, insbesondere das in der Praxis am meisten verwendete Sputtern vom keramischen Target, haben den Nachteil, dass sie bei wirtschaftlich interessanten Abscheideraten keine vertikale Variation der Konzentration des Dotierungsmaterials erlauben. Das trifft insbesondere für das in der Praxis weit verbreitete Sputtern vom keramischen Target zu. Bei diesem Verfahren ist die Konzentration der Bestandteile bereits durch die Zusammensetzung des Targets bestimmt. Allenfalls der Sauerstoffgehalt kann während der Beschichtung durch den zusätzlichen Einlass von Sauerstoff variiert werden. Die Situation beim reaktiven Sputtern ist ähnlich. Hier besteht das Target aus einer Legierung der Metalle, die für das Wirts- und das Dotiermaterial vorgesehen sind. Die Konzentrationen der Bestandteile legen damit zugleich das Verhältnis des Wirts- und des Dotiermaterials in der Schicht fest. In ähnlicher Weise trifft das für die Laserablation zu. Die chemische Dampfabscheidung erlaubt zwar die Änderung der Konzentration der Schichtbestandteile, indem die Zuflussmengen der in eine Vakuumkammer eingelassenen Gase verändert werden. Der vergleichsweise hohe Arbeitsdruck (im Bereich 10⁴ Pa in oben genanntem Zitat) ermöglicht keine schnelle Veränderung der Zusammensetzung des Gasgemisches in der Vakuumkammer speziell bei großflächigen Beschichtungen. Eine Veränderung der Schichtzusammensetzung im Schichtdickenverlauf lässt sich damit nur in ungenügendem Ausmaß erzielen.

Mit bekannten Verfahren ist daher eine transparente leitfähige Schicht mit einem Gradienten im Schichtdickenverlauf nur herstellbar, wenn mehrere Beschichtungsstationen nacheinander eingesetzt werden, was wiederum einen erhöhten Aufwand bei der Installation der Anlagen bedeutet und den Herstellungsprozess durch zusätzliche Transportschritte aufwändiger gestaltet.

### Aufgabenstellung

Der Erfindung liegt daher das technische Problem zugrunde, ein Verfahren zum Abscheiden transparenter leitfähiger Schichten sowie eine transparente leitfähige Schicht aus einem Metalllegierungsoxid zu schaffen, mittels denen die Nachteile des Standes der Technik überwunden werden. Insbesondere sollen die Schichten einen geringen spezifischen Widerstand und somit eine hohe elektrische Leitfähigkeit aufweisen. Desweiteren soll mit dem erfindungsgemäßen Verfahren eine Schicht mit einem gegenüber dem Stand der Technik steileren Gradienten der Dotiermaterialkonzentration innerhalb einer Vakuumkammer abscheidbar sein.

Die Lösung des technischen Problems ergibt sich durch die Gegenstände mit den Merkmalen des Anspruchs 1. Weitere vorteilhafte Ausgestaltungen der Erfindung ergeben sich aus den abhängigen Patentansprüchen.

Bei einem erfindungsgemäßen Verfahren wird innerhalb einer Vakuumkammer auf einem Substrat eine transparente, elektrisch leitfähige Schicht aus einem Metalllegierungsoxid abgeschieden. Dabei umfasst das Metalllegierungsoxid sowohl ein Wirtsmaterial als auch ein Dotiermaterial. Als Wirtsmaterial werden entweder Zinkoxid oder Indiumoxid verwendet, die in Bezug auf das schichtbildende Metalllegierungsoxid einen molaren Anteil von mindestens 90 % ausmachen. Zur Erhöhung der elektrischen Leitfähigkeit wird in das Wirtsmaterial ein Dotiermaterial eingetragen, welches ein Oxid mindestens eines metallischen oder halbmetallischen Elements aus den Hauptgruppen III oder IV umfasst. Besonders geeignet sich dabei die Elemente Bor, Aluminium, Gallium und Indium (Indium natürlich nur bei der Verwendung von Zinkoxid als Wirtsmaterial). Mit diesen Elementen wurden besonders gute Ergebnisse hinsichtlich der Verbesserung der Leitfähigkeit des Wirtsmaterials erzielt.

Das erfindungsgemäße Verfahren zeichnet sich weiterhin dadurch aus, dass das Wirtsmaterial mittels eines PVD-Prozesses, wie beispielsweise Sputtern oder auch alle Arten des Vakuumverdampfens, abgeschieden wird. Das Dotiermaterial wird in das Wirtsmaterial eingetragen, indem während des PVD-Abscheideprozesses des Wirtsmaterials in die Vakuumkammer neben einem Arbeitsgas auch noch Sauerstoff und ein Precursor eingelassen werden, wobei der Precursor das metallische oder halbmetallische Element aus den Hauptgruppen III oder IV enthält. Der in die Vakuumkammer einströmende Precursor wird in der Vakuumkammer aufgespalten und die aufgespaltenen Bestandteile zu chemischen Reaktionen mit anderen in der Vakuumkammer befindlichen Partikeln angeregt. Auf diese Weise oxidiert auch das im Precursor enthaltene metallische oder halbmetallische Element mit dem in der Vakuumkammer befindlichen Sauerstoff und wird als Dotiermaterial in das Wirtsmaterial während des Schichtaufbaus eingelagert. Das metallische oder halbmetallische Element aus der Hauptgruppe III oder IV wird nachfolgend vereinfachend nur noch "Dotierelement" genannt und dessen Oxid als "Dotierelementoxid" bezeichnet.

Es versteht sich, dass neben dem Dotierelementoxid prozessbedingt auch noch andere Spaltprodukte des Precursors, wie beispielsweise das Dotierelement selber, im nichtoxidierten Zustand bzw. andere Reaktionsprodukte von in der Vakuumkammer stattfindenden chemischen Reaktionen in das Wirtsmaterial eingelagert werden können. Diese sind jedoch nicht erfindungswesentlich und somit kein Gegenstand dieser Beschreibung. Erfindungswesentlich ist jedoch, dass die Zuflussmenge des in die Vakuumkammer eingelassenen Precursors nur so hoch eingestellt wird, dass die Summe der in das Wirtsmaterial eingelagerten Partikel 10 % des molaren Anteils vom abgeschiedenen Schichtmaterial nicht übersteigt.

Das Dotieren eines Wirtsmaterials erhöht dessen Leitfähigkeit, weil mit dem Dotiermaterial die Anzahl an Ladungsträgern erhöht wird. Gleichzeitig wirkt das Dotiermaterial jedoch auch als Störstelle im Gitter des Wirtsmaterials und schränkt dadurch die Beweglichkeit der Ladungsträger ein. Es ist daher vorteilhaft für eine elektrisch leitfähige Schicht, wenn diese über die Schichtdicke betrachtet einen Gradienten bezüglich der Konzentration des Dotiermaterials aufweist, weil sich dann eine Teilschicht mit hoher Konzentration des Dotiermaterials ausbildet, welche zusätzliche Ladungsträger bereitstellt und auch eine Teilschicht mit geringerer Dotiermaterialkonzentration ausbildet, welche dafür aber eine höhere Beweglichkeit der Ladungsträger aufgrund weniger Störstellen im Wirtsmaterialgitter ermöglicht.

Bei einem erfindungsgemäßen Verfahren wird daher eine transparente leitfähige Schicht abgeschieden, die im Schichtdickenverlauf einen Gradienten bezüglich der Konzentration des Dotiermaterials aufweist.

Die Kombination des Abscheidens des Wirtsmaterials mit einem PVD-Prozess bei gleichzeitigem Einlass relativ geringer Mengen eines Precursors in die Vakuumkammer, der ein Element des Dotiermaterials enthält, eröffnet mehrere Möglichkeiten, die Konzentration des Dotiermaterials im Schichtdickenverlauf zu verändern.

Bei einem Substrat, dass während des Beschichtens bewegt wird, kann ein Konzentrationsgradient des Dotiermaterials im Schichtdickenverlauf zum Beispiel eingestellt werden, indem die Einlassöffnung für den Precursor in Bewegungsrichtung des Substrates betrachtet vor oder/und nach der Einrichtung zum Abscheiden des Wirtsmaterials angeordnet wird. Eine Einlassöffnung vor dieser Einrichtung bewirkt eine hohe Konzentration des Dortiermaterials am Schichtboden, die mit dem Schichtwachstum kontinuierlich abnimmt. Umgekehrt verhält es sich, wenn eine Einlassöffnung für den Precursor nach der Einrichtung zum Abscheiden des Wirtsmaterials angeordnet wird. Dann weist die Schicht an der Schichtoberfläche die höchste Konzentration des Dotiermaterials auf, die zum Schichtboden hin geringer wird.

Beim Anordnen einer Einlassöffnung vor und einer Einlassöffnung nach der Einrichtung zum Abscheiden des Wirtsmaterials können die beiden geschilderten Konzentrationsprofile für das Dotiermaterial im Schichtdickenverlauf auch überlappt werden. Bei einer Ausführungsform werden die Zuflussmengen des Precursors vor und nach einer Einrichtung zum Abscheiden des Wirtsmaterials derart eingestellt, dass die abgeschiedene Schicht am Schichtboden und an der Schichtoberfläche jeweils ein Maximum der Konzentration des Dotiermaterials aufweist. Somit bildet sich am Schichtboden und an der Schichtoberfläche jeweils eine Teilschicht, die eine hohe Ladungsträgerdichte aufweist. Zwischen diesen beiden Teilschichten gibt es eine Teilschicht, in welcher sich die von den beiden Schichtseiten bereitgestellten Ladungsträger entlang des Schichtmaterials mit einer hohen Beweglichkeit ausbreiten können. Eine auf solche Weise abgeschiedene Schicht weist eine hohe Leitfähigkeit auf.

Mit dem erfindungsgemäßen Verfahren können aber nicht nur Substrate im bewegten Zustand beschichtet werden, um mit einem Konzentrationsgradienten des Dotiermaterials im Schichtdickenverlauf ausgebildet zu werden, sondern dies ist auch beim Beschichten von Substraten im unbewegten Zustand möglich.

Ein Konzentrationsgradient des Dotiermaterials im Schichtdickenverlauf kann erfindungsgemäß auch eingestellt werden, indem beispielsweise die Zuflussmenge des Precursors in die Vakuumkammer verändert wird. Je geringer die Zuflussmenge des Precursors bei gleichbleibender Abscheiderate des Wirtsmaterials eingestellt wird, umso geringer wird die Konzentration des Dotiermaterials im abgeschiedenen Schichtmaterial.

Alternativ oder auch zusätzlich kann die Abscheiderate des Wirtsmaterials verändert werden. Wird das Wirtsmaterial beispielsweise mittels eines Magnetron-Sputterverfahrens abgeschieden, kann zum Beispiel die in das Magnetron eingespeiste elektrische Leistung verändert werden, um die Abscheiderate des Wirtsmaterials zu verändern. Je höher die Abscheiderate des Wirtsmaterials bei gleichbleibender Zuflussmenge des Precursors ist, umso geringer wird die Konzentration des Dotiermaterials innerhalb des abgeschiedenen Schichtmaterials.

Bei diesen Ausführungsformen kann ein Substrat sowohl im ruhenden Zustand als auch im bewegten Zustand erfindungsgemäß beschichtet werden. Bei einem im ruhenden Zustand beschichteten Substrat weist die abgeschiedene Schicht über die Substratfläche betrachtet sowohl homogene Eigenschaften der Schicht hinsichtlich der Schichtzusammensetzung als auch hinsichtlich der elektrischen Eigenschaften auf.

Wird ein Substrat im bewegten Zustand beschichtet und dabei die Konzentration des Dotiermaterials verändert, indem beispielsweise die Precursorzuflussmenge verändert wird oder auch die Abscheiderate des Wirtsmaterials variiert, ist es nachvollziehbar, dass sich auch die Schichtzusammensetzung in Bewegungsrichtung des Substrates betrachtet verändert, d. h. die abgeschiedene Schicht weist bei dieser Form der Schichtabscheidung auch einen Konzentrationsgradienten des Dotiermaterials in Bewegungsrichtung des Substrates auf. Die elektrischen Eigenschaften der abgeschiedenen Schicht bleiben aber auch bei dieser Ausführungsform über die Substratfläche hinweg betrachtet zumindest nahezu homogen, wenn das Verändern der Precursorzuflussmenge bzw. das Verändern der Abscheiderate des Wirtsmaterials periodisch derart erfolgt, dass zumindest eine vollständige Periode des Veränderns der Durchflussmenge bzw. der Abscheiderate des Wirtsmaterials innerhalb der Zeitspanne durchgeführt wird, in der ein Punkt auf der Oberfläche des Substrates vollständig am Beschichtungsfenster vorbeigeführt wird. Diese Zeitspanne wird nachfolgend auch Beschichtungszeit genannt.

An dieser Stelle sei angemerkt, dass man die Zusammensetzung des Gasgemisches in einer Vakuumkammer infolge einer Zuflussmengenänderung eines Precursors bei einem erfindungsgemäßen Verfahren aufgrund des beim Magnetron-Sputtern oder auch beim Vakuumverdampfen vorherrschenden Niederdrucks in der Vakuumkammer und bei den für das Dotieren erforderlichen geringen Precursorzuflussmengen problemlos innerhalb eines einstelligen Sekundenbereichs und wenn erforderlich auch innerhalb eines Zehntelsekundenbereichs durchführen kann. Dadurch kann im Schichtdickenverlauf der abgeschiedenen Schicht ein sehr steiler Gradient der Dotiermaterialkonzentration eingestellt werden. Infolgedessen ist es auch möglich, über die Schichtdicke betrachtet eine Vielzahl von Maxima der Dotiermaterialkonzentration auszubilden. Dann wechseln sich mehrfach Teilschichten mit hoher Ladungsträgerdichte und Teilschichten mit hoher Ladungsträgerbeweglichkeit ab, was sich positiv auf die Leitfähigkeit der Schicht auswirkt. Wird ein Substrat während des Beschichtens bewegt, verlaufen die Maxima der Dotiermaterialkonzentration wellenförmig innerhalb der Schichtebene in Bewegungsrichtung des Substrates.

Bei einer Ausführungsform wird die Zuflussmenge des das Dotierelement enthaltenden Precursors so schnell variiert, dass die zwei benachbarten Maxima der Dotiermaterialkonzentration im Schichtdickenverlauf maximal 500 nm voneinander beabstandet sind. Bei einer bevorzugten Ausführungsform sind die beiden Maxima maximal 150 nm voneinander beabstandet. Damit ist eine sehr hohe elektrische Leitfähigkeit des abgeschiedenen Schichtmaterials realisierbar.

Als Dotierelement enthaltender Precursor können alle bekannten Precursoren verwendet werden, in denen eines oder mehrere der oben benannten Dotierelemente enthalten ist/sind. Beispielhaft seien hier die Precursoren TEOS, TMS, SiH₄, AlCl₃, B(CH₃)₃, B(C₂H₅)₃ Al(CH₃)₃, B₂H₆, Al(C₂H₅)₃ genannt.

Vorteilhaft ist es ebenfalls, wenn der Precursor neben einem Dotierelement gleichzeitig auch noch ein Halogen enthält. Es ist bekannt, dass bei Anwesenheit eines Halogens im Gasgemisch der Vakuumkammer einige Sauerstoffmoleküle im Gitter des Wirtsmaterials durch das Halogen ersetzt werden, wodurch eine weitere Verbesserung der Leitfähigkeit erzielt werden kann.

Eine erfindungsgemäße transparente leitfähige Schicht aus einem Metalllegierungsoxid besteht aus einem Wirtsmaterial und einem Dotiermaterial, wobei das Wirtsmaterial Zinkoxid oder Indiumoxid ist und wobei das Dotiermaterial ein Oxid mindestens eines der metallischen oder halbmetallischen Elemente aus der Hauptgruppe III oder IV umfasst. Dabei weist die Konzentration des Dotiermaterials im Schichtdickenverlauf mindestens zwei Maxima auf. Bei einer Ausführungsform verlaufen die beiden Maxima wellenförmig in der Schichtebene.

### Ausführungsbeispiel

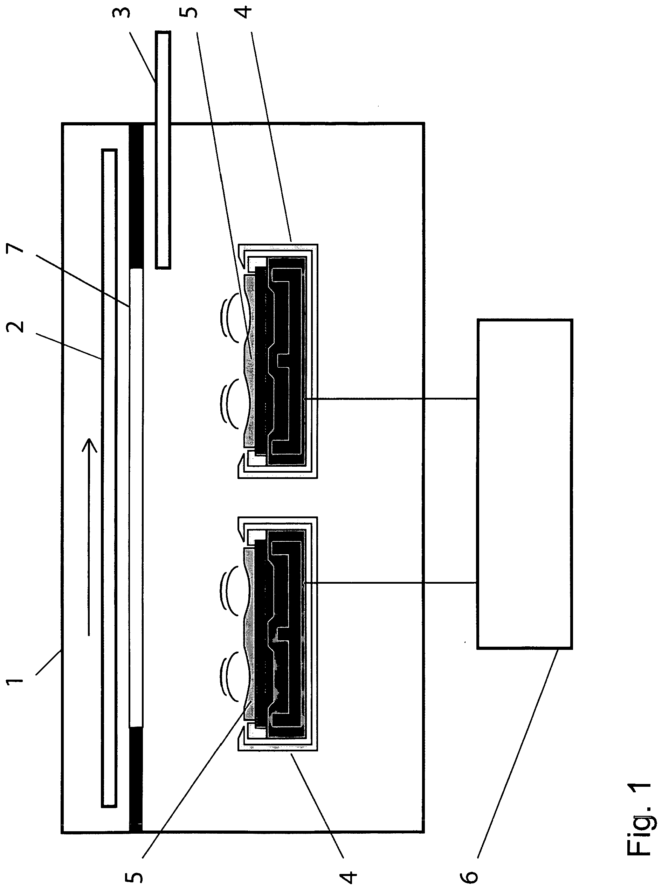

Die Erfindung wird nachfolgend anhand eines Ausführungsbeispiels näher erläutert. Fig. 1 zeigt eine schematische Darstellung einer Vorrichtung, mittels der das erfindungsgemäße Verfahren durchgeführt werden kann. Die Vorrichtung aus Fig. 1 umfasst eine Vakuumkammer 1, in welcher auf der Oberfläche eines als PET-Folie ausgebildeten Substrates 2 eine transparente leitfähige Schicht abgeschieden wird, die als größten Schichtbestandteil Zinkoxid aufweist. Das schichtbildende Zinkoxid wird durch einen reaktiven Magnetron-Sputterprozess auf dem Substrat 2 abgeschieden. D. h. neben dem für das Magnetron-Sputtern verwendete Arbeitsgas Argon wird auch noch Sauerstoff durch einen Einlass 3 in die Vakuumkammer 1 eingelassen, wobei das Argon mit 150 sccm und der Sauerstoff mit 70 sccm in die Vakuumkammer 1 strömt.

Mittels zweier Magnetrons 4, auf denen sich jeweils ein 127 mm² x 350 mm² großes Zinktarget 5 befindet, werden Zinkpartikel abgestäubt, die sich in Reaktion mit dem in der Vakuumkammer 1 befindlichen Sauerstoff als Zinkoxid auf der Substratoberfläche abscheiden. Dabei wird mit Hilfe einer zwischen beide Magnetrons 4 geschalteten bipolaren Stromversorgungseinrichtung 6 mit einer Leistung von 6 kW eine Gasentladung gezündet, wobei jedes der beiden Magnetrons 4 abwechselnd als Kathode oder Anode der Gasentladung geschaltet wird.

Zur Erhöhung der elektrischen Leitfähigkeit wird das als Wirtsmaterial fungierende Zinkoxid mit Siliziumoxidpartikeln dotiert. Hierfür wird während des reaktiven Magnetron-Sputterns der Zinktargets 5 der gasförmige und Silizium-haltige Precursor Tetraethylorthosilicat (TEOS) ebenfalls durch den Einlass 3 in die Vakuumkammer 1 eingelassen. Unter der Einwirkung des Magnetron-Plasmas wird der Precursor aufgespalten und die Spaltprodukte zu chemischen Reaktionen angeregt. Auf diese Weise geht auch das im TEOS enthaltene Silizium chemische Verbindungen ein und wird auch in Form von Siliziumoxid als Dotiermaterial im abgeschiedenen Zinkoxidgitter eingelagert.

Während des Beschichtungsvorgangs wird das Substrat 2 mit einer Geschwindigkeit von 0,1 m/min in Bewegungsrichtung des Substrates 2 an einem 40 cm langen Beschichtungsfenster 7 vorbeigeführt. Ein Punkt auf der Oberfläche des Substrates 2 braucht demnach 4 min, bis er einmal vollständig am Beschichtungsfenster vorbeigeführt wird.

Weiterhin wird die Precursorzuflussmenge während des Beschichtens periodisch verändert. Dabei wird die Zuflussmenge innerhalb von 60 s kontinuierlich von 0 sccm auf 7 sccm erhöht, anschließend innerhalb von 60 s von 7 sccm auf 0 sccm verringert, dann wieder innerhalb von 60 s auf 7 sccm erhöht usw.

Die Periode des Erhöhens und Verringerns der Precursorzuflussmenge wird demnach während der Beschichtungszeit zweimal vollständig durchlaufen, so dass sich über die Dicke der abgeschiedenen Schicht zwei Maxima bezüglich der Konzentration des Dotiermaterials ausbilden. Weil das Substrat während des Beschichtens bewegt wird, verlaufen diese beiden Maxima innerhalb der Schichtebene wellenförmig in Beschichtungsrichtung. Die Beschichtungsrichtung des Substrates 2 ist in Fig. 1 mit einem Pfeil dargestellt.

Bei den geschilderten Abscheidebedingungen wurde eine transparente leitfähige Schicht mit einer Dicke von 700 nm abgeschieden. Sie hatte eine Transparenz von mehr als 70 % und einen Schichtwiderstand von 40 Q pro Flächeneinheit.

Im beschriebenen Beispiel wurde die Zuflussmenge des Precursors innerhalb von 60 s zwischen Minimum und Maximum verändert. Wie zuvor schon einmal dargelegt, ist dieser Wechsel auch im einstelligen Sekundenbereich oder gar im Zehntelsekundenbereich durchführbar. Dies gilt auch, wenn an Stelle der beiden Magnetrons 4 mindestens ein Verdampfertiegel angeordnet wird, in dem dann das zum Wirtsmaterial gehörende Zink oder Indium verdampft wird.

## Patentansprüche

1. Verfahren zum Abscheiden einer transparenten leitfähigen Schicht, umfassend ein Wirtsmaterial und ein Dotiermaterial, auf einem Substrat (2) innerhalb einer Vakuumkammer (1), wobei das Wirtsmaterial aus Zinkoxid oder Indiumoxid besteht und das Dotiermaterial ein Oxid mindestens eines der metallischen oder halbmetallischen Elemente aus der Hauptgruppe III oder IV umfasst, **dadurch gekennzeichnet, dass** während des Abscheidens des Wirtsmaterials mittels eines PVD-Prozesses Sauerstoff und ein Precursor in die Vakuumkammer (1) eingelassen werden, wobei der Precursor das mindestens eine Element aus der Hauptgruppe III oder IV enthält und dass die Konzentration des Dotiermaterials im Schichtdickenverlauf mit einem Gradienten ausgebildet wird.

2. Verfahren nach Anspruch 1, **dadurch gekennzeichnet, dass** der Gradient ausgebildet wird, indem die Zuflussmenge des Precursors in die Vakuumkammer (1) oder/und die Abscheiderate des Wirtsmaterials zeitabhängig verändert wird/werden.

3. Verfahren nach Anspruch 1 oder 2, **dadurch gekennzeichnet, dass** der Konzentrationsgradient des Dotiermaterials im Schichtdickenverlauf mit mindestens zwei Maxima ausgebildet wird.

4. Verfahren nach Anspruch 3, **dadurch gekennzeichnet, dass** die zwei Maxima im Schichtdickenverlauf mit einem Abstand von maximal 500 nm ausgebildet werden.

5. Verfahren nach Anspruch 4, **dadurch gekennzeichnet, dass** die zwei Maxima im Schichtdickenverlauf mit einem Abstand von maximal 150 nm ausgebildet werden.

6. Verfahren nach einem der Ansprüche 1 bis 5, **dadurch gekennzeichnet, dass** das Substrat im stationären Zustand beschichtet wird.

7. Verfahren nach einem der Ansprüche 1 bis 5, **dadurch gekennzeichnet, dass** das Substrat (2) im bewegten Zustand beschichtet wird.

## Claims

1. Process for depositing a transparent conductive layer, comprising a host material and a doping material, on a substrate (2) within a vacuum chamber (1), where the host material consists of zinc oxide or indium oxide and the doping material comprises an oxide of at least one of the metallic or semi-metallic elements of main group III or IV, **characterized in that** oxygen and a precursor are admitted into the vacuum chamber (1) during the deposition of the host material by means of a PVD process, where the precursor contains the at least one element of main group III or IV, and **in that** the concentration of the doping material has a gradient over the layer thickness.

2. Process according to Claim 1, **characterized in that** the gradient is formed by the inflow amount of the precursor into the vacuum chamber (1) and/or the deposition rate of the host material being altered as a function of time.

3. Process according to Claim 1 or 2, **characterized in that** the concentration gradient of the doping material over the layer thickness has at least two maxima.

4. Process according to Claim 3, **characterized in that** the two maxima over the layer thickness are at a distance of not more than 500 nm from one another.

5. Process according to Claim 4, **characterized in that** the two maxima over the layer thickness are at a distance of not more than 150 nm from one another.

6. Process according to any of Claims 1 to 5, **characterized in that** the substrate is coated in the stationary state.

7. Process according to any of Claims 1 to 5, **characterized in that** the substrate (2) is coated in the moving state.

## Revendications

1. Procédé de dépôt d'une couche conductrice transparente, comprenant un matériau hôte et un matériau dopant, sur un substrat (2) dans une chambre sous vide (1), le matériau hôte étant constitué d'oxyde de zinc ou d'oxyde d'indium et le matériau dopant comprenant un oxyde d'au moins un des éléments métalliques ou semi-métalliques du groupe principal III ou IV, **caractérisé en ce que**, pendant le dépôt du matériau hôte au moyen d'un procédé PVD, de l'oxygène et un précurseur sont introduits dans la chambre sous vide (1), le précurseur contenant ledit au moins un élément du groupe principal III ou IV, et **en ce que** la concentration du matériau dopant dans l'épaisseur de couche est formée avec un gradient.

2. Procédé selon la revendication 1, **caractérisé en ce que** le gradient est formé par variation en fonction du temps de la quantité introduite de précurseur dans la chambre sous vide (1) et/ou du taux de dépôt du matériau hôte.

3. Procédé selon la revendication 1 ou 2, **caractérisé en ce que** le gradient de concentration du matériau dopant dans l'épaisseur de couche est formé avec au moins deux maxima.

4. Procédé selon la revendication 3, **caractérisé en ce que** les deux maxima sont formés dans l'épaisseur de couche à un écart d'au plus 500 nm.

5. Procédé selon la revendication 4, **caractérisé en ce que** les deux maxima sont formés dans l'épaisseur de couche à un écart d'au plus 150 nm.

6. Procédé selon l'une quelconque des revendications 1 à 5, **caractérisé en ce que** le substrat est revêtu à l'état stationnaire.

7. Procédé selon l'une quelconque des revendications 1 à 5, **caractérisé en ce que** le substrat (2) est revêtu à l'état mobile.
